Europäisches Patentamt

European Patent Office

Office européen des brevets

(19)

(11) Veröffentlichungsnummer: **0 152 802**
**A2**

(12) **EUROPÄISCHE PATENTANMELDUNG**

(21) Anmeldenummer: 85100755.9

(22) Anmeldetag: 25.01.85

(51) Int. Cl.⁴: **G 06 F 1/00**

(30) Priorität: 20.02.84 CH 813/84

(43) Veröffentlichungstag der Anmeldung: 28.08.85
Patentblatt 85/35

(84) Benannte Vertragsstaaten: DE FR GB IT NL SE

(71) Anmelder: **Renata AG, Kreuzenstrasse 30,
CH-4452 Itingen (CH)**

(72) Erfinder: **Wyser, Paul, Dorfstrasse 3, CH-4452 Itingen
(CH)**
Erfinder: **Uebelhart, Heinrich, Gartenstrasse 43,
CH-4452 Itingen (CH)**

(74) Vertreter: **Gehrig, Peter et al, A. Braun, Braun, Héritier,
Eschmann AG Holbeinstrasse 36-38, CH-4051 Basel
(CH)**

(54) **Batteriegestütztes integriertes Schaltelement.**

(57) Das Schaltelement enthält im Innern eines napfförmigen Kunststoffgehäuses (3) eine gasdichte Primärbatterie (B) und eine im Gehäuse-Hohlraum (3') neben der Batterie (B) angeordnete Beschaltungsanordnung mit Halbleiterschaltelementen (D₁, Tr) und Leiterverbindungen (8, 13/13', 15, 16). Batterie (B) und Beschaltungsanordnung sind durch eine Vergußmasse (19) hermetisch im Gehäuse (3) angeordnet.

Das Schaltelement ist mit auf seine Oberfläche herausgeführten Steckstiften (13/13', 16) versehen, die direkt in eine Leiterplatte einlötbar sind. Schaltelemente dieser Art sind insbesondere als Reservespannungsquelle für Speichersysteme der nicht-selbsthaltenden Art verwendbar.

## Batteriegestütztes integriertes Schaltelement

Die vorliegende Erfindung bezieht sich auf ein batteriegestütztes integriertes Schaltelement.

In elektronischen Speicherschaltungen mit Fremdspannungsspeisungen ist es üblich, nicht selbsthaltende Speicherschaltungen mit externen Batterien zu beschalten, um einem Verlust von Speicherinhalten bei Ausfall der Fremdspannung zu vermeiden. Dieses Vorgehen ist beim Aufbau solcher Schaltungen, insbesondere bei der Ausrüstung von Leiterplatten nachteilig, weil einesteils die Beschaltungsglieder für den Batteriebetrieb separat anzuordnen sind, und andernteils die Batterien sich aus verschiedenen Gründen schlecht für den Einbau mit Beschickungsautomaten und das Verlöten auf dem Fliessband eignen. Zudem sollten solche Batterien für Langzeitbetrieb geeignet sein und vorzugsweise für die ganze Lebenszeit einer Speicherschaltung betriebsbereit bleiben. Eine ohne besondere Schutzmassnahmen gegen Korrosion, Verschmutzung, Feuchtigkeit und dergleichen Ursachen für Leck-Leistungsverluste auf eine Leiterplatte aufgesetzte Batterie ist daher latent gefährdet und bietet wenig Sicherheit für Betriebsbereitschaft im langjährigen Einsatz.

Die Aufgabe der vorliegenden Erfindung ist daher ein batteriegestütztes integriertes Schaltelement zu schaffen, bei der die Batterie samt der zu ihrem Betrieb notwendigen Beschaltungsglieder in einem hermetisch verschlossenen Gehäuse untergebracht sind, und nur die für eine spezifische Schaltgliederorganisation typischen Anschlussklemmen für direkten Einbau auf eine Leiterplatte über das Bauteil herausragen.

Die Lösung dieser Aufgabe ist durch die kennzeichnenden Merkmale des Patentanspruchs 1 definiert. Besondere Ausführungsformen davon sind durch die abhängigen Ansprüche gekennzeichnet.

Ausführungsbeispiele des erfindungsgemässen Schaltelementes sind nachstehend anhand von Schematas eines Reservespeisegliedes und zwei Ausführungsformen beschrieben. In der Zeichnung zeigen die

Fig. 1a-c Schaltungsbeispiele zur Verwendung im Schaltelement, und die

Fig. 2a, b und 3a, b je eine Grundriss- und eine teilweise geschnittene Seitenansicht des Schaltelementes.

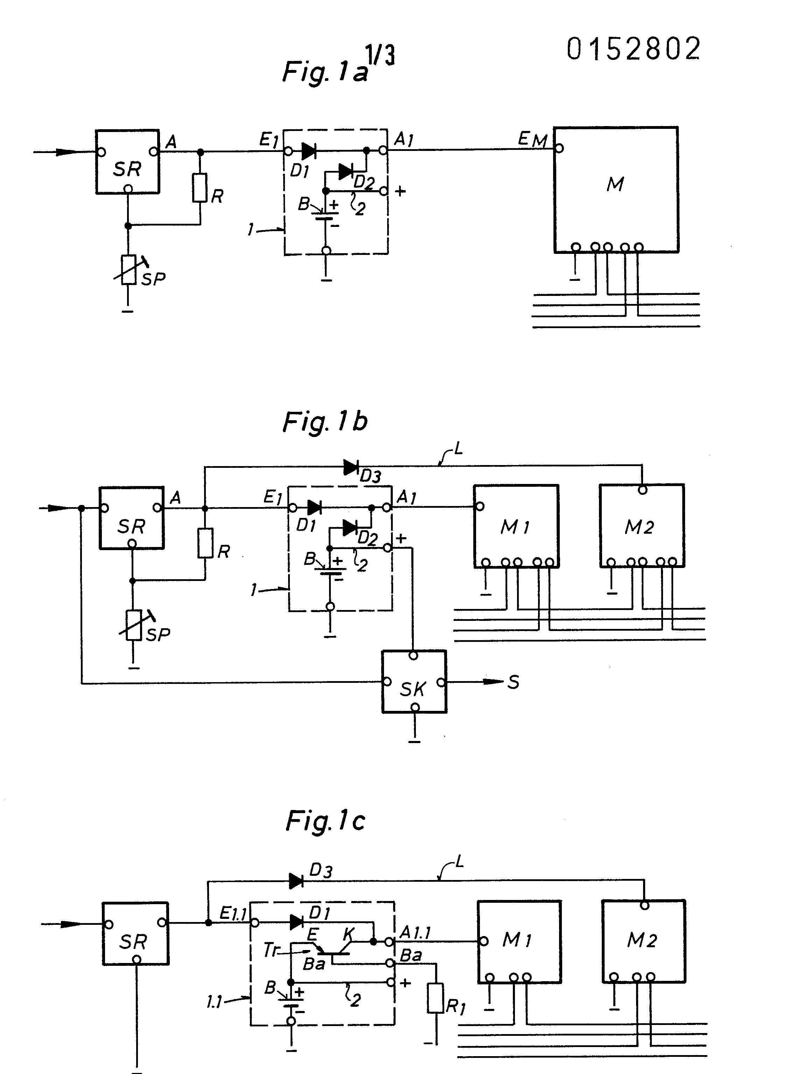

In Fig. 1a ist ein integriertes Schaltelement 1 nach der Erfindung in einer Speicherspeiseschaltung mit einem mit Rückkopplungsmitteln R und einem Steuerpotentiometer SP beschalteten Speisespannungsregler SR gezeigt, der dem Schaltelement 1 eingangsseitig vorgeschaltet ist. Der Ausgang A des Speisespannungsreglers SR ist direkt mit dem Eingang $E_1$ des Schaltelementes 1 verbunden.

- 3 - 0152802

M bezeichnet allgemein ein Speichersystem, in dem zumindest ein Teil der Speicherglieder zur Aufrechterhaltung ihres Speicherzustandes entweder stets an Spannung liegen müssen, oder einen Speicherzustand nur bei kurzzeitigem Speisespannungsausfall aufrechtzuhalten vermögen. Das Schaltelement 1 enthält im vorliegenden Fall eine Halbleiter-Beschaltungsanordnung mit einem im Leiterzug $E_1$-$A_1$ liegende Diode $D_1$, welche für den Fall, dass die Fremdspannungsanspeisung funktioniert, die nötige Betriebsspannung an den Speichersystemzugang $E_M$ anlegt.

Das Schaltelement 1 enthält weiterhin eine ein- oder mehrzellige Primär-Batterie B mit extrem langer Lebensdauer, beispielsweise eine Lithiumbatterie des gasdichten Typs, deren Plus-Pol über eine zweite Diode $D_2$ in Stromflussrichtung nach der Diode $D_1$ an den Leiterzug $E_1$-$A_1$ angeschlossen ist. Zweckmässig ist der Plus-Pol der Batterie B über eine interne Verbindung 2 an die extern zugängliche Plusklemme (+) des Schaltelementes 1 gelegt. Dadurch lässt sich beispielsweise der Ladezustand der Batterie überwachen. Gleichermassen ist der Minus-Pol der Batterie direkt an die extern zugängliche Minusklemme (-) des Schaltelementes 1 geführt.

Betriebsmässig liegt am Eingang $E_1$ eine Spannung, die etwas über der Langzeit-Betriebsspannung der Batterie B liegt. Damit ist sichergestellt, dass bei spannungsführendem Eingang $E_1$ an $D_2$ eine Sperrspannung liegt, die einen Stromfluss von der Batterie B zum Ausgang $A_1$ verhindert. Die Anspeisung des Speichersystems M erfolgt somit von der Fremdspannungsquelle über den Spannungsregler SR, den Eingang $E_1$ am Schaltelement 1 und die Diode $D_1$.

- 4 -

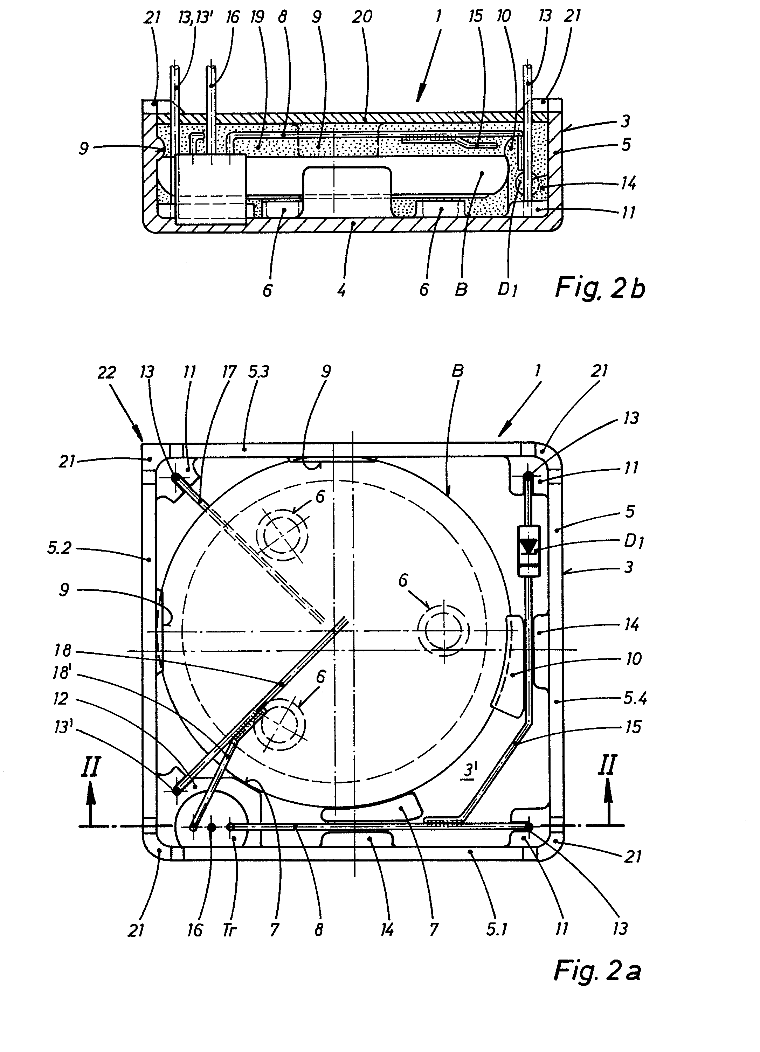

Fällt die beschriebene Fremdspannungsanspeisung aus, so ermöglicht die Diode 2 den Stromfluss von der Batterie B zum Ausgang $A_1$ und zum
Speichersystemeingang $E_M$. Eingang $E_1$, Ausgang $A_1$
und die Klemmen (+) und (-) am Schaltelement sind in
der Form von Steckstiften (siehe in Fig. 2a, b und
3a, b) aus dessen körperlichen Bereich herausgeführt.

Fig. 1b zeigt das Schaltelement 1 der oben
beschriebenen Ausführungsform in einer komplexen
Speicherschaltung mit einem Speichersystem $M_1$ mit
nicht-selbsthaltenden Speichergliedern und einem
Speichersystem $M_2$, das keine andauernde Anspeisung verlangt.
Letzteres ist unter Umgehung des Schaltelementes 1
über eine externe Diode $D_3$ und die Leitung L mit dem
Eingang A des Spannungsreglers SR, welcher im Prinzip
gleich beschaltet sein kann wie in Fig. 1a gezeigt,
verbunden. Das Speichersystem $M_1$ entspricht dem oben
erwähnten Speichersystem M und ist unter Zwischenschaltung eines wirkungsmässig gleichen Schaltelementes 1 an die Fremdstromquelle bzw. den Spannungsregler SR angeschlossen. Der Unterschied besteht im
wesentlichen darin, dass die Schaltung nach Fig. 1b
weiterhin eine Spannungsvergleichs- oder Ueberwachungsschaltung SK, die bei Ausfall der Fremdspeisespannung
auf einen Abfall unterhalb einem Schwellwert ein Anzeigesignal S liefert, enthält.

Eine weitere Schaltungsvariante in Anlehnung
an Fig. 1b zeigt die Fig. 1c in vereinfachter Darstellungsweise. Das in letztgenannter Figur gezeigte
Schaltelement 1.1 enthält anstelle der zweiten Diode $D_2$
aus den früheren Figuren einen Transistor Tr, dessen Emitter E mit dem Plus-Pol der Batterie B, und dessen Kollektor K mit dem Eingang des Speichersystems $M_1$ verbunden ist. Die Basis Ba des Transistors ist über einen Widerstand $R_1$ an den Minus-Pol der Schaltung angeschlossen. Die Art der Speichersysteme $M_1$ und $M_2$ entspricht im Prinzip derjenigen gemäss Fig. 1b. Die Funktion der im Schaltelement 1.1 internen Schaltung entspricht derjenigen aus den Fig. 1a und 1b. Indessen ermöglicht die Verwendung eines Transistors (inklusive eines Feldeffekttransistors) den Spannungsabfall gegenüber der Diode wesentlich zu senken. Es tritt daher ein erheblich geringerer Spannungsabfall auf, wodurch die nutzbare Kapazität der Batterie erhöht werden kann.

Grundsätzlich ist die Schaltelement-interne Beschaltung nicht auf die in den Fig. 1a-c gezeigten Beispiele beschränkt. Auch ist die Anzahl der Anschlussstiften entsprechend den Klemmen $E_1$, $A_2$, +/- usw., nicht limitiert, so dass z.B. bei Schaltelementen 1, 1.1 mit zwei oder mehr in Serie geschalteten Batterien auch Zwischenspannungsabgriffe herausführbar sind, um z.B. unabhängige Schaltungs- oder Speicherabschnitte und dergleichen mit Teilspannungen betreiben zu können.

Eine erste praktische Ausgestaltung des Schaltelementes 1 ist in den Fig. 2a und 2b gezeigt. Aus je einer Grundriss- und einer Schnittdarstellung (nach der Linie II-II in Fig. 2a) ist die Lage der Batterie B innerhalb eines napfförmigen Kunststoffgehäuses 3 ersichtlich. Das Kunststoffgehäuse ist in der "Einfüll"-Stellung für die Schaltungskomponenten gezeigt und steht demnach auf dem Kopf, d.h. die obenliegend dargestellten Bestandteile liegen in Gebrauchsstellung unten. Demgemäss ist die als Basisteil des Gehäuses gezeigte Platte 4 in Wirklichkeit die Deckplatte des Gehäuses 1, an welche die Seitenwände 5 nahtlos anschliessen. Im Hohlraum 3' des Gehäuses sind Zentriermittel sowohl für die Batterie B als auch für die Schaltungskomponenten angeordnet bzw. einstückig angeformt, nämlich a) eine Anzahl etwa gleichmässig verteilt angeordneter Abstandshalter 6 (gezeigt sind drei) zur Sicherung der Batterie B in etwa paralleler Ausrichtung zur Deckplatte 4, b) seitliche Abstandshalter 7, welche die Batterie B gegenüber der Seitenwand 5.1 distanzieren, um Platz für ein Leiterelement 8 zu sichern, c) an den Seitenwänden 5.2 und 5.3 angeformte Haltenasen 9, und d) ein Klemmspannglied 10, welches die Batterie B im wesentlichehen wie die Haltenasen 9 übergreift, und diese zusätzlich gegen weitere Anschlagglieder, im gezeigten Beispiel  die Seitenwände 5.2 und 5.3 drängt.

Das Gehäuse 3 ist ferner mit Ecksockeln 11, 12 zur Aufnahme des einen Endes von über das Gehäuse 3 hinausragenden Steckstiften 13,13' versehen, sowie mit Klemmnocken 14 zur örtlichen Fixierung von Leiterelementen 8 und 15. Der Ecksockel 12 ist zweckmässig so gestaltet, dass er aussen zur Aufnahme eines Steckstiftes auch zum Zentrieren des Transistors Tr oder gegebenenfalls einer Diode (z.B. $D_2$ nach Fig. 1a, 1b) verwendbar ist. Die Anordnung der Diode $D_1$ im Leiterelement 15 kann an irgendeiner Stelle dieses Leiterelementes erfolgen, wo ausreichend Abstand gegenüber der Batterieoberfläche besteht.

Die Steckstifte 13, 13' sind in einem asymmetrischen Flächenmuster angeordnet, durch das Anschlussverwechslungen ausgeschlossen sind. Dabei liegen die drei Steckstiften 13 zweckmässig in drei Ecken einer quadratischen Konfiguration, während der vierte Steckstift 13' ausserhalb dieser Konfiguration angeordnet ist. Ein im Falle des Transistors Tr weiterer Steckstift 16 kann direkt auf die Basis- oder Gate-Elektrode aufgesetzt sein.

Die in Abwandlungen der beschriebenen Halterungsmittel 6, 7, 9, 10 auf mannigfache Weise im Inneren des Gehäuses 3 festlegbare Batterie B kann, versehen mit Polanschlussleitern 17, 18 durch Fingerdruck in seine Halterung eingebracht werden. Nach dem Einsetzen der Steckstiften 13, 13' werden die Schaltungskomponenten Tr und $D_1$ samt ihren Leiterverbindungen eingebracht und der verbliebene Hohlraum anschliessend mit einem elektrisch isolierenden und gegenüber dem Elektrolyten der Batterie beständigen aushärtbaren Giessharz 19 frei von Lufteinschlüssen vergossen. Noch vor dem Aushärten des Giessharzes 19 kann die Gehäuseöffnung mit einer wenigstens teilweise auf dem Giessharz aufliegenden Abschlussplatte 20 verschlossen werden, deren Oberfläche mit dem Oeffnungsrand bündig ist. Die Abschlussplatte 20 enthält dabei mit den Oeffnungen in den Ecksockeln 11, 12 korrespondierende Oeffnungen für die obere Führung der Steckstiften 13 sowie des Stiftes 16.

Um das Schaltelement 1 bei Montage auf einer Leiterplatte von dieser im Abstand zu halten, sind in den Ecken der Seitenwände 5.1-5.4 Nocken 21 aufgesetzt. Damit die Anschluss-kongruente Orientierung der Schaltelemente auch von deren Oberseite her - also ohne Orientierung nach der Steckstiftenkonfiguration - rasch und

- 8 -

0152802

sicher erfolgen kann, ist eine davon als Pass-Ecke 22 abweichend von den anderen gestaltet.

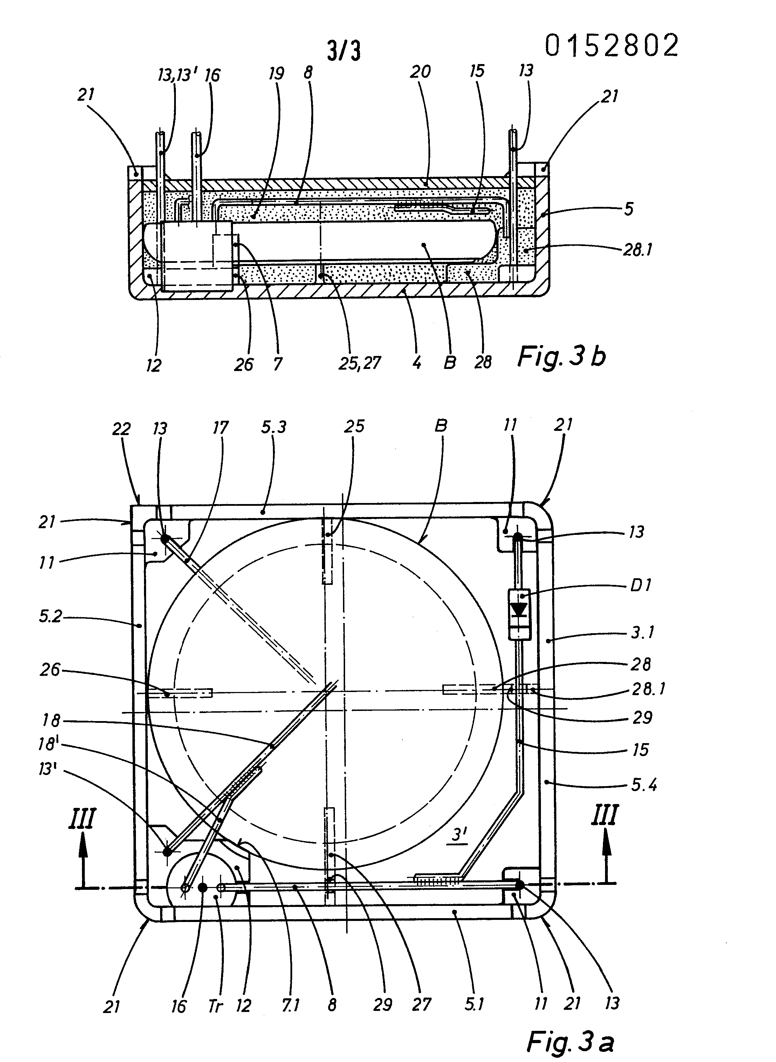

In den Fig. 3a, 3b ist eine Ausführungsform des Schaltelementes gezeigt, die äusserlich mit demjenigen nach den Fig. 2a, 2b übereinstimmt und diesbezüglich nicht weiter beschrieben sein soll. Ebenso ist ein innerer Schaltungsaufbau gezeigt, der dem oben beschriebenen entspricht. Wesentlich einfacher ist dagegen die Halterung der Batterie B im Hohlraum des Gehäuses 3.1. Hiezu vorgesehen sind vier Basisstützstege 25, 26, 27, 28, die von den jeweils benachbarten Seitenwänden 5.1-5.4 ausgehend die Unterseite der Batterie B untergreifen. Im gezeigten Beispiel ist die Batterie B seitlich durch die Gehäuse-Seitenwände 5.2, 5.3, den Abstandshalter 7.1 am Ecksockel 12 und am erhöhten Teil 28.1 des Basisstützsteges 28 im Gehäuse 3.1 zentriert. Der Ecksockel 12 ist praktisch gleich wie in den Fig. 2a, 2b gestaltet und für die Halterung des Transistors Tr oder eines entsprechenden anderen Schaltelementes, und des Steckstiftes 13' vorgesehen. Die Basisstützstege 27, 28 bzw. der erhöhte Teil 28.1 des letzteren sind mit Klemmnuten 29 für die Fixierung der Leiterelemente 8 und 15 innerhalb des Gehäuses 3.1 und im Abstand von der Batterie B versehen.

Fig. 3b entspricht dem Schnitt längs der Linie III-III in Fig. 3a.

Die Batterie B, die Leiterelemente 8, 15, 17, 18, 18', die Steckstiften 13, 13' und die Schaltungsglieder Tr und $D_1$ werden zweckmässig ausserhalb des Gehäuses miteinander zusammengeschaltet und vor oder nach dem Einfüllen des Giessharzes 19 in dem Hohlraum des Gehäuses 3, 3.1 in diesen eingesetzt.

Eine mit Durchtrittsöffnungen im Verteilungsmuster entsprechend den Oeffnungen in den Ecksockeln 11, 12 - als untere Führungselemente gestaltet - versehene Abschlussplatte 20 überdeckt den Gehäusehohlraum 3'.

Es versteht sich, dass das Gehäuse 3, 3.1 in Form und Grösse variierbar ist und mit an sich beliebig gestaltbaren inneren Stütz- und Zentriermitteln versehen sein kann, um eine Batterie und die zugehörige Beschaltung aufnehmen zu können.

Patentansprüche

1. Batteriegestütztes integriertes Schaltelement, gekennzeichnet durch ein napfförmiges Gehäuse (3; 3') mit einem Hohlraum (3'), enthaltend
- eine Primär-Batterie (B) des gasdichten Typs; eine Anzahl die Batterie (B) im Gehäuse-Hohlraum (3') gegen eine Deckplatte (4) distanzierende Abstandshalter (6; 25-28) und eine Anzahl die Batterie im Gehäuse-Hohlraum (3') seitlich zentrierende Anschlagelemente (5.2, 5.3, 7, 10; 5.2, 5.3, 7,1, 28.1);
- eine Beschaltungsanordnung aus Halbleiterschaltele-menten ($D_1$, $D_2$, Tr) und Leiterverbindungen (8, 13/13', 15-18/18') sowie eine Anzahl die Beschaltungselemente im Gehäuse-Hohlraum festlegende Halteeinrichtungen (11, 12, 14, 29); und
- eine die Batterie (B) und die Beschaltungselemente im Gehäuse-Hohlraum gasdicht umhüllende Vergussmasse (19).

2. Schaltelement nach Anspruch 1, dadurch ge-kennzeichnet, dass die Leiterverbindungen vorzugsweise in den Hohlraum-Eckbereichen angeordnete Steckstiften (13, 13') umfassen, deren eines Ende in einem mit dem Gehäuse (3) verbundenen Sockel (11, 12) zentriert ist.

3. Schaltelement nach Anspruch 1, dadurch gekennzeichnet, dass die die Batterie (B) seitlich zentrierenden Anschlagelemente mit die Batterie nachgiebig umfassende Glieder (9, 10) versehen sind.

4. Schaltelement nach Anspruch 2, dadurch gekennzeichnet, dass die Gehäuseöffnung mit einer wenigstens teilweise auf der Vergussmasse (19) aufliegenden Abschlussplatte (20) verschlossen ist, welche mit die Steckstiften (13, 13') in der Nähe ihres äusseren Endes zentrieren.

5. Schaltelement nach einem der Ansprüche 1 bis 4, dadurch gekennzeichnet, dass die Gehäuse-Seitenwände (5.1-5.4) vorzugsweise in den Eckbereichen mit vorspringenden Distanznocken (21) versehen sind, und dass einer dieser Eckbereiche als Passecke (22) abweichend von den übrigen Eckbereichen gestaltet ist.

6. Schaltelement nach einem der Ansprüche 1 bis 5, dadurch gekennzeichnet, dass die Beschaltungsanordnung eine in einen Durchführungs-Leiterzug ($E_1$-$A_1$) eingebaute in Stromdurchtrittsrichtung gepolte Diode ($D_1$) und eine weitere, den Plus-Pol der Batterie (B) hinter der ersten Diode ($D_1$) mit dem Durchführungs-Leiterzug ($E_1$-$A_1$) verbindende Diode ($D_2$) enthält.

7. Schaltelement nach einem der Ansprüche 1 bis 5, dadurch gekennzeichnet, dass die Beschaltungsanordnung eine in einen Durchführungs-Leiterzug ($E_{1.1}$-$A_{1.1}$) eingebaute in Stromdurchtrittsrichtung gepolte Diode ($D_1$) und einen den Plus-Pol der Batterie (B) hinter der Diode ($D_1$) mit dem Durchführungs-Leiterzug ($E_{1.1}$-$A_{1.1}$) verbindenden Transistor (Tr) enthält.

E

Fig. 1a $^{1/3}$

0152802

Fig. 1b

Fig. 1c

*Fig. 2b*

*Fig. 2a*

0152802

*Fig. 3 b*

*Fig. 3 a*